# EUROPEAN PATENT APPLICATION

(11) **EP 4 660 646 A1**
(43) Date of publication of application: **10.12.2025**
(21) Application number: 25175239.0
(22) Date of filing: 09.05.2025
(51) Int. Cl.: G01R 31/3835, G01R 31/392

(54) **BATTERY DIAGNOSIS DEVICE AND METHOD**

(30) Priority: 05.06.2024 KR 20240073804
(71) Applicant: SAMSUNG SDI CO., LTD., Yongin-si, Gyeonggi-do 17084 (KR)
(72) Inventor: KIM, Yong Chan, 16678 Suwon-si, Gyeonggi-do (KR); YOON, Seon Hye, 16678 Suwon-si, Gyeonggi-do (KR); KIM, Hye Won, 16678 Suwon-si, Gyeonggi-do (KR); LEE, Jae Young, 16678 Suwon-si, Gyeonggi-do (KR); OH, Jeong Won, 16678 Suwon-si, Gyeonggi-do (KR)
(74) Representative: Gulde & Partner

(57) **Abstract**

A battery diagnosis device and method, and a battery pack are disclosed. A battery diagnosis device includes a configuration for diagnosing an abnormality of a battery cell (10a) in a manner of analyzing a change in behavior of a cell voltage change rate that appears when the battery cell (10a) is discharged in a state in which a state of charge, SOC, of the battery cell (10a) has been formed as a predefined reference SOC.

## Description

### BACKGROUND

### 1. Field

Aspects of embodiments of the present disclosure relate to a battery diagnosis device and method, and a battery pack.

### 2. Description of the Related Art

Secondary batteries are batteries that can be charged and discharged, unlike primary batteries that cannot be recharged. Low-capacity secondary batteries may be used in small portable electronic devices, such as smartphones, feature phones, laptop computers, digital cameras, and camcorders, and high-capacity secondary batteries are widely used as motor driving power sources, power storage batteries, and the like in hybrid vehicles, electric vehicles, and the like. These secondary batteries (that is, battery cells) include an electrode assembly including a positive electrode, a negative electrode, and a separator interposed between the positive electrode and the negative electrode, a case which accommodates the electrode assembly, an electrode terminal connected to the electrode assembly, and the like. Charging and discharging of the battery cells are performed in a manner in which an electrolyte is injected into a case of the battery cells and an electrochemical reaction between the positive electrode, the negative electrode, and the electrolyte is performed. The case of the battery cells may be implemented in any of various shapes, such as a cylindrical shape, rectangular shape, or the like depending on the use of the battery cells, for example.

In the battery cells, an internal short circuit phenomenon in which the positive and negative electrodes in the battery cell are short-circuited due to loss of function of the separator can occur. The internal short circuit in the battery cell can occur due to deformation caused by an external impact, metallic foreign substances introduced during a manufacturing process, or dendrite formation of lithium or copper due to an electrochemical reaction. This internal short circuit in the battery cell can cause a safety issue, such as thermal runaway.

Further, in the case of secondary batteries applied to electric vehicles or high-capacity systems such as energy storage systems (ESSs), a long lifespan, high output characteristics, and safety are desired due to the characteristics of the high-capacity systems. Specifically, in the case of batteries into which scrap-type foreign substances including abnormal metallic foreign substances or base materials have been introduced, a lithium salt can grow around a region where the foreign substances have been introduced, and a phenomenon in which the lithium salt penetrates a separator under pressurized conditions in which cell swelling is limited by an external partition can occur, and, accordingly, there is a risk of thermal runaway occurring due to the internal short circuit in the battery cell.

The above information disclosed in this Background section is provided for enhancement of understanding of the background of the present disclosure, and, therefore, it may contain information that does not constitute the related (or prior) art.

### SUMMARY

According to an aspect of one or more embodiments of the present disclosure, a battery diagnosis device and method capable of diagnosing a battery cell abnormality such as an internal short circuit in the cell due to lithium salt precipitation, which may occur in a lithium ion battery, in advance, and a battery pack, are provided.

However, aspects and objects of the present invention are not limited to the above-described aspects and objects and other aspects and objects that are not described may be clearly understood by those skilled in the art from the following description.

According to one or more embodiments of the present disclosure, a battery diagnosis device includes: a processor configured to diagnose an abnormality of a battery cell; and a memory to store one or more commands executed by the processor, wherein the processor is configured to diagnose the abnormality of the battery cell by analyzing a behavior of a cell voltage change rate that appears when the battery cell is discharged in a state in which a state of charge (SOC) of the battery cell has been formed (or established) as a reference SOC (e.g., a predefined reference SOC).

### BRIEF DESCRIPTION OF THE DRAWINGS

The following drawings included with this specification illustrate some embodiments of the present disclosure, and further describe aspects and features of the present disclosure together with the detailed description of the present disclosure. However, the present disclosure should not be construed as being limited to the drawings, in which:
FIG. 1 illustrates a prismatic battery according to an embodiment of the present disclosure;
FIG. 2 illustrates a cross-sectional view of the prismatic battery of FIG. 1;
FIG. 3 illustrates a battery module according to an embodiment of the present disclosure;
FIGS. 4A and 4B illustrate a battery pack according to an embodiment of the present disclosure;
FIG. 5 illustrates a block configuration diagram of a battery diagnosis device according to an embodiment of the present disclosure;
FIGS. 6 and 7 illustrate examples of a process of analyzing the behavior of a cell voltage change rate of battery cells in the battery diagnosis device according to an embodiment of the present disclosure; and
FIGS. 8 and 9 illustrate flowcharts of a battery diagnosis method according to some embodiments of the present disclosure.

### DETAILED DESCRIPTION

Herein, some embodiments of the present disclosure will be described in further detail with reference to the accompanying drawings. The terms or words used in this specification and claims are not to be construed as being limited to their usual or dictionary meaning and are to be interpreted as having meanings and concepts consistent with the technical idea of the present disclosure based on the principle that the inventor can be his/her own lexicographer to appropriately define the concept of the term to explain his/her invention in the best way.

The embodiments described in this specification and the configurations shown in the drawings are only some embodiments of the present disclosure and do not necessarily represent all of the technical ideas, aspects, and features of the present disclosure. Accordingly, it is to be understood that there may be various equivalents and modifications that can replace or modify the embodiments described herein at the time of filing this application.

It is to be understood that when an element or layer is referred to as being "on," "connected to," or "coupled to" another element or layer, it may be directly on, connected, or coupled to the other element or layer, or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element, or the first element may be indirectly coupled or connected to the second element via one or more intervening elements.

In the drawings, dimensions of various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It is to be understood that, although the terms "first," "second," "third," etc. may be used herein to describe various elements, components, regions, layers, and/or sections, these elements, components, regions, layers, and/or sections are not to be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the drawings. It is to be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein are to be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It is to be further understood that the terms "includes," "including," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all sub-ranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, the applicant reserves the right to amend this specification, including the claims, to expressly recite any sub-range subsumed within the ranges expressly recited herein.

References to two compared elements, features, etc. as being "the same" may mean that they are the same or substantially the same. Thus, the phrase "the same" or "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it is to be understood that when an element is referred to as being "coupled," "linked," or "connected" to another element, the elements may be directly "coupled," "linked," or "connected" to each other, or one or more intervening elements may be present therebetween, through which the element may be "coupled," "linked," or "connected" to another element. In addition, when a part is referred to as being "electrically coupled" to another part, the part can be directly connected to another part or one or more intervening parts may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

### 1. Battery structure

Prior to a detailed description of some embodiments, first, a structure of a battery which is an abnormality diagnosis target in one or more embodiments will be generally described.

### Prismatic battery

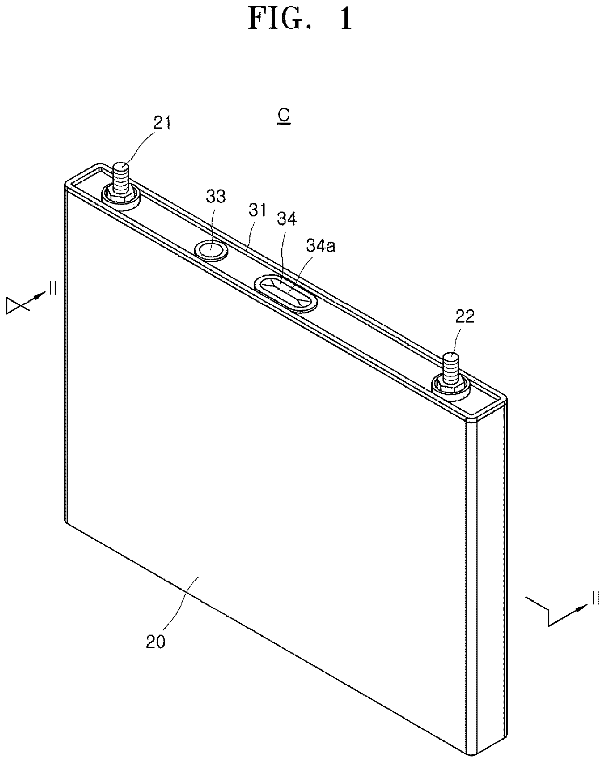

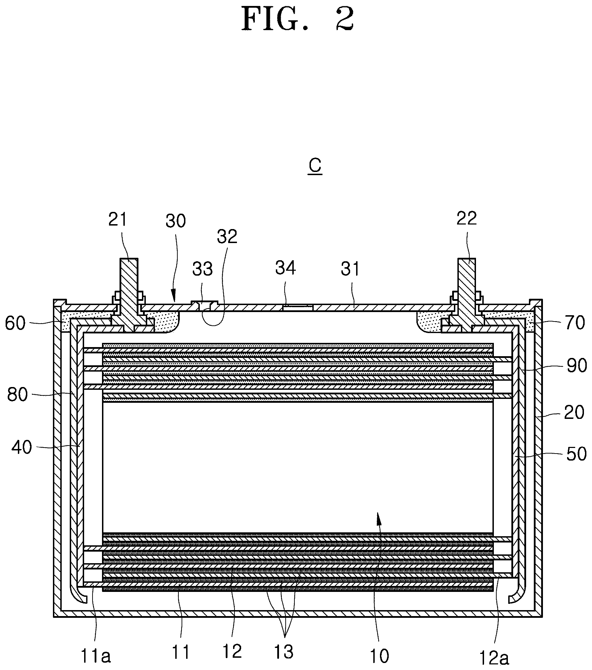

FIG. 1 is a perspective view illustrating a secondary battery according to an embodiment; and FIG. 2 is a cross-sectional view along the line II-II in FIG. 1.

Referring to FIGS. 1 and 2, a secondary battery C according to one or more embodiments of the present disclosure may include at least one electrode assembly 10 wound with a separator 13 as an insulator between a positive electrode 11 and a negative electrode 12, a case 20 in which the electrode assembly 10 is received (or accommodated) therein, and a cap assembly 30 coupled to an opening of the case 20.

The secondary battery C according to one or more embodiments illustrated in FIGS. 1 and 2 will now be described as an example of a prismatic lithium ion secondary battery. However, the present disclosure is not limited thereto, and suitable aspects, features and principles described herein may be applied to various other types of batteries, such as lithium polymer batteries and/or cylindrical batteries, for example.

Each of the positive electrode 11 and the negative electrode 12 may include a current collector made of a thin metal foil having a coated portion on which an active material is coated and a respective uncoated portion 11a, 12a on which an active material is not coated.

In an embodiment, the positive electrode 11 and the negative electrode 12 are wound after interposing the separator 13, which is an insulator, therebetween. However, the present disclosure is not limited thereto, and the electrode assembly 10 may have a structure in which a positive electrode 11 and a negative electrode 12, each made of a plurality of sheets, are alternately stacked with a separator interposed therebetween.

The case 20 may form an overall outer appearance of the secondary battery C and may be made of a conductive metal, such as aluminum, an aluminum alloy, or nickel-plated steel. In addition, the case 20 may provide a space in which the electrode assembly 10 is accommodated.

The cap assembly 30 may include a cap plate 31 covering the opening in the case 20, and the case 20 and the cap plate 31 may be made of a conductive material. Positive and negative electrode terminals 21 and 22 electrically connected to the positive electrode 11 and the negative electrode 12, respectively, may be installed to penetrate (or extend through) the cap plate 31 and protrude outwardly therethrough.

In an embodiment, outer peripheral surfaces (e.g., circumferential surfaces) of upper pillars of the positive and negative electrode terminals 21 and 22 protruding outwardly from the cap plate 31 may be threaded and may be fixed to the cap plate 31 by utilizing nuts.

However, the present disclosure is not limited thereto, and the positive and negative electrode terminals 21 and 22 may have a rivet structure and may be riveted or welded to the cap plate 31, for example.

In an embodiment, the cap plate 31 may be made of a thin plate and may be coupled to the opening in the case 20, and an electrolyte injection port 32 into which a sealing stopper 33 may be installed may be located (e.g., formed) in the cap plate 31, and a vent portion 34 having a notch 34a may be installed or included.

The positive and negative electrode terminals 21 and 22 may be electrically connected to current collectors including first and second current collectors 40 and 50 (herein referred to as positive and negative current collectors) by being bonded or coupled (e.g., by welding) to the positive electrode uncoated portion 11a and the negative electrode uncoated portion 12a, respectively.

For example, the positive and negative electrode terminals 21 and 22 may be coupled by welding to the positive and negative electrode current collectors 40 and 50, respectively. However, the present disclosure is not limited thereto, and the positive and negative electrode terminals 21 and 22 and the positive and negative electrode current collectors 40 and 50 may be integrally formed in one or more embodiments.

In addition, an insulation member may be installed between the electrode assembly 10 and the cap plate 31. The insulation member may include first and second lower insulation members 60 and 70, and each of the first and second lower insulation members 60 and 70 may also have a portion located between the electrode assembly 10 and the case 20.

According to one or more embodiments of the present disclosure, an end of a separation member may face a side of the electrode assembly 10 and may be installed between the insulation member and the positive or negative electrode terminals 21 and 22.

In one or more embodiments, the separation member may include first and second separation members 80 and 90.

In such an embodiment, first ends of the first and second separation members 80 and 90 installed to face a side of the electrode assembly 10 may be respectively installed between the first and second lower insulation members 60 and 70 and the positive and negative electrode terminals 21 and 22.

Accordingly, the positive and negative electrode terminals 21 and 22, which may be coupled by welding to the positive and negative electrode current collectors 40 and 50, may be coupled to first ends of the first and second lower insulation members 60 and 70 and the first and second separation members 80 and 90.

### Battery module

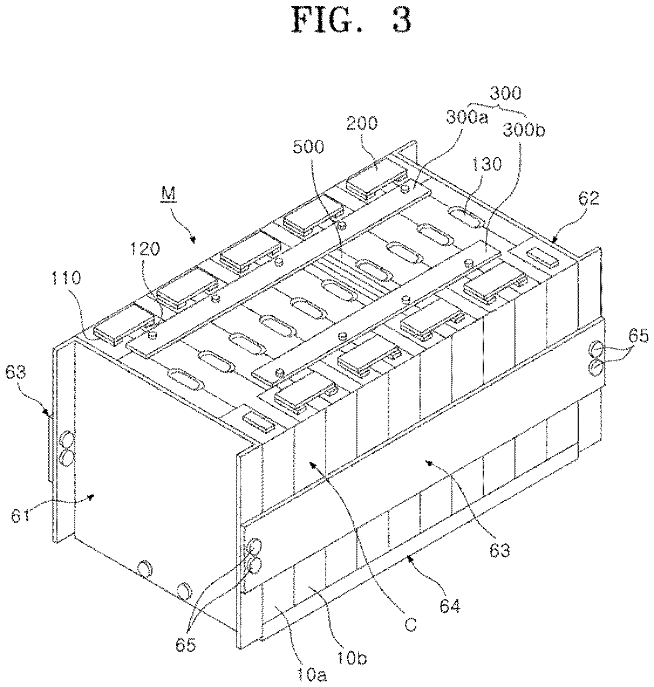

FIG. 3 is a perspective view illustrating a battery module according to an embodiment of the present disclosure.

Referring to FIG. 3, a battery module M according to one or more embodiments of the present disclosure includes electrode units 110 and 120, a plurality of battery cells C arranged in a direction, a connection tab 200 connecting a battery cell 10a to an adjacent battery cell 10b, and a protection circuit module 300 having an end connected to the connection tab 200. In an embodiment, the protection circuit module 300 may include a battery management system (BMS). Further, the connection tab 200 may include a body portion in contact with the electrode units 110 and 120 between the adjacent battery cells 10a and 10b and an extension portion extending from the body portion and connected to the protection circuit module 300. The connection tab 200 may be, for example, a bus bar.

Each battery cell C may include a battery case, an electrode assembly received (or accommodated) in the battery case, and an electrolyte. The electrode assembly and the electrolyte react electrochemically to store and release (e.g., generate) energy. Electrode units, or terminal portions, 110 and 120 electrically connected to the connection tab 200 and a vent 130 as a discharge passage for gas generated inside the battery case may be provided on a side of (e.g., an upper side of) the battery cell C. The terminal portions 110 and 120 of the battery cell 10 may be a positive electrode terminal 110 and a negative electrode terminal 120 having different polarities from each other, and the terminal portions 110 and 120 of the adjacent battery cells 10a and 10b may be electrically connected to each other in series or parallel by the connection tab 200, to be described in further detail below. Although a serial connection is illustrated as an example, the connection structure is not limited thereto, and any of various connection structures may be employed as desired or necessary. In addition, a number and arrangement of battery cells is not limited to the structure shown in FIG. 3 and may be changed as desired or necessary.

The plurality of battery cells C may be arranged in (e.g., may be stacked in) a direction such that wide surfaces of the battery cells C face each other, and the plurality of battery cells C may be fixed by housings (or housing elements) 61, 62, 63, and 64. The housings (or housing elements) 61, 62, 63, and 64 may include a pair of end plates 61 and 62 facing the wide surfaces of the battery cells C and a side plate 63 and a bottom plate 64 connecting the pair of end plates 61 and 62 to each other. The side plate 63 may support side surfaces of the battery cells 10, and the bottom plate 64 may support bottom surfaces of the battery cells 10. In an embodiment, the pair of end plates 61 and 62, the side plate 63 and the bottom plate 64 may be connected by bolts 65 and/or any other suitable fastening members and methods known to those of ordinary skill in the art.

The protection circuit module 300 may have electronic components and protection circuits mounted thereon and may be electrically connected to connection tabs 200, to be described in further detail later. In an embodiment, the protection circuit module 300 includes a first protection circuit module 300a and a second protection circuit module 300b extending in different locations along the direction in which the plurality of battery cells C are arranged. The first protection circuit module 300a and the second protection circuit module 300b may be spaced by a suitable interval (e.g., a predetermined interval) from each other and arranged parallel to each other to be electrically connected to adjacent connection tabs 200, respectively. In an embodiment, for example, the first protection circuit module 300a extends on one side of the upper portion of the plurality of battery cells C along the direction in which the plurality of battery cells C is arranged, and the second protection circuit module 300b extends on another side of the upper portion of the plurality of battery cells C along the direction in which the plurality of battery cells C is arranged. The second protection circuit module 300b may be spaced by a suitable interval (e.g., a predetermined interval) from the first protection circuit module 300a with the vents 34 interposed therebetween and may be disposed parallel to the first protection circuit module 300a. As such, the two protection circuit modules are disposed in parallel and spaced apart from each other in the direction in which the plurality of battery cells C is arranged, thereby reducing or minimizing an area of a printed circuit board (PCB) constituting the protection circuit module 300. By separately configuring the protection circuit module 300 into two protection circuit modules, an unnecessary PCB area can be reduced or minimized. The first protection circuit module 300a and the second protection circuit module 300b may be connected to each other by a conductive connection member 500. A side of the conductive connection member 500 is connected to the first protection circuit module 300a, and another side of the conductive connection member 500 is connected to the second protection circuit module 300b such that the two protection circuit modules 300a and 300b can be electrically connected with each other.

The connection may be performed by any of soldering, resistance welding, laser welding, projection welding, and/or any other suitable connection methods known to those of ordinary skill in the art.

In an embodiment, the connection member 500 may be, for example, an electrical wire. In addition, the connection member 500 may be made of a material having elasticity or flexibility. Through the connecting member 500, it may be possible to check and manage whether the voltage, temperature, and/or current of the battery cells C are normal. For example, the information received by the first protection circuit module 300a from connection tabs adjacent to the first protection circuit module 300a, such as voltage, current, and/or temperature, and the information received from connection tabs adjacent to the second protection circuit module 300b, such as voltage, current, and/or temperature, may be integrated and managed by the protection circuit module 300 through the connection member 500.

In addition, if the battery cell C swells, impacts may be absorbed by the elasticity or flexibility of the connection member 500, thereby preventing or substantially preventing the first and second protection circuit modules 300a and 300b from being damaged.

However, a shape and structure of the connection member 500 is not limited to the shape and structure shown in FIG. 3.

As described above, since the protection circuit module 300 is provided as the first and second protection circuit modules 300a and 300b, the area of the PCB constituting the protection circuit module can be reduced or minimized, and a space inside the battery module can be secured, which improves work efficiency by facilitating fastening work for connecting the connection tab 200 and the protection circuit module 300 and repair work if (or when) an abnormality is detected in the battery module M.

### Battery Pack

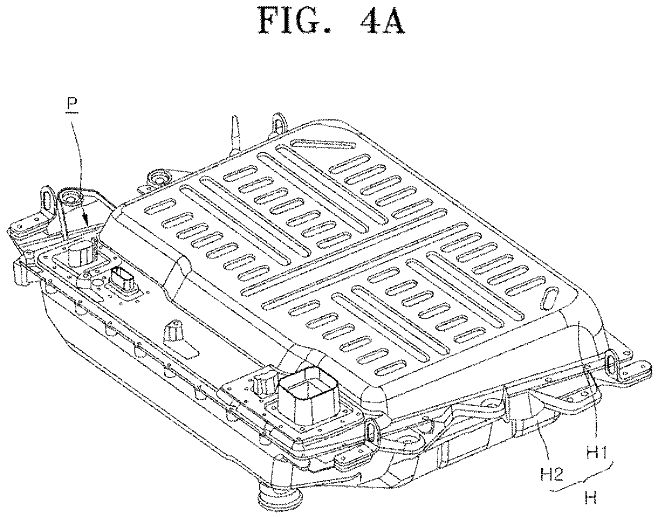

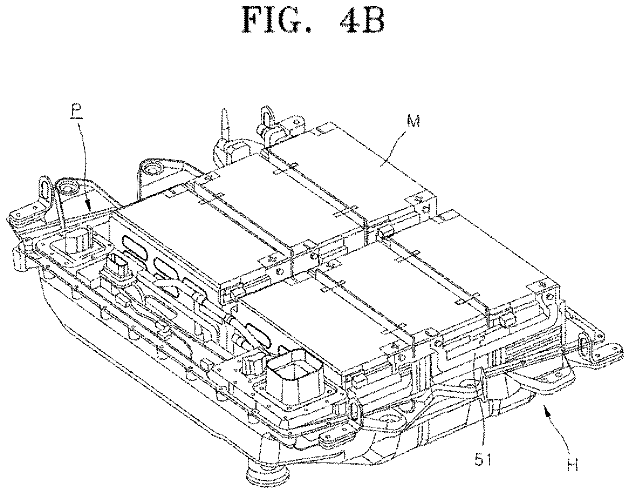

FIGS. 4A and 4B are views illustrating a battery pack according to an embodiment of the present disclosure.

A battery pack P may include a plurality of battery modules M and a housing H for accommodating the plurality of battery modules M. For example, the housing H may include first and second housings H1 and H2 coupled in opposite directions through the plurality of battery modules M. For example, the first and second housings H1 and H2 may be arranged on opposite sides of the plurality of battery modules M. The plurality of battery modules M may be electrically connected to each other using a bus bar 51, and the plurality of battery modules M may be electrically connected to each other in a series/parallel or mixed series-parallel method, thereby obtaining a desired (e.g., required) electrical output.

### 2. Battery diagnosis device

Based on the above-described battery structure, herein, in an embodiment, a method of diagnosing a battery cell abnormality will be described in further detail.

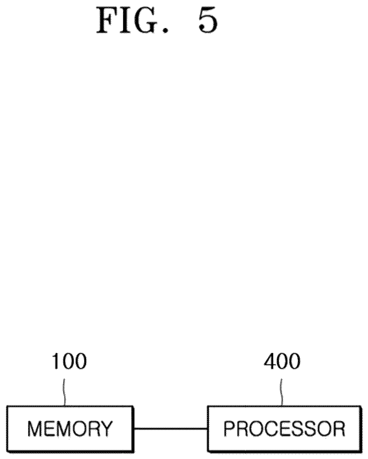

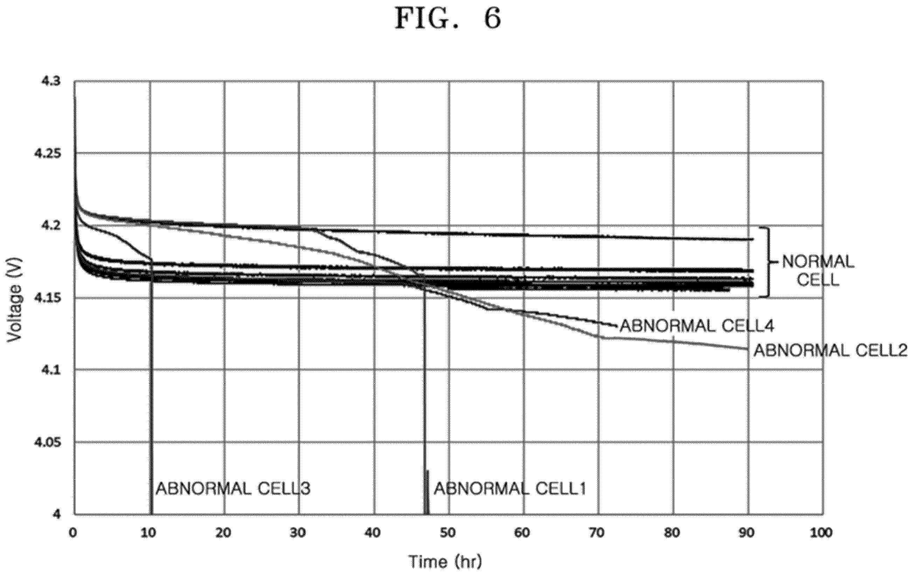

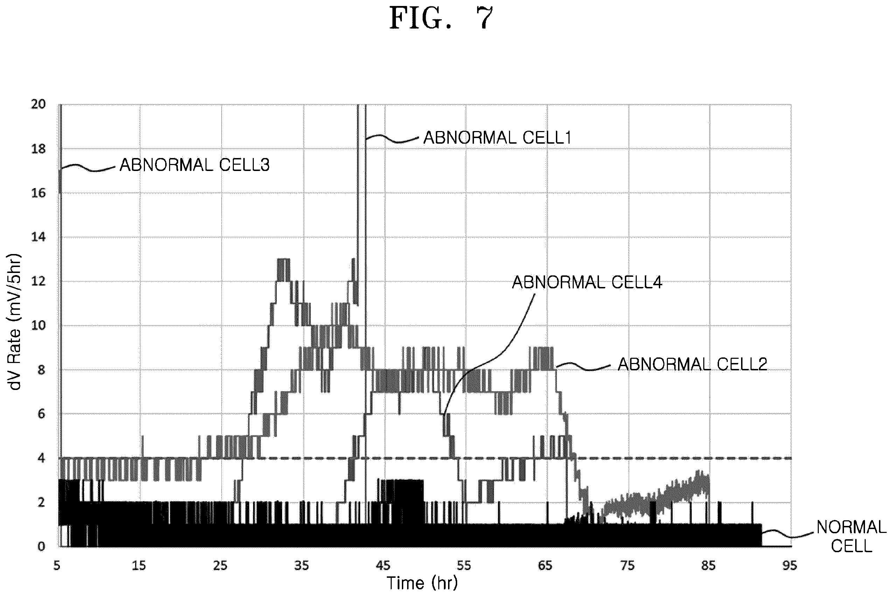

FIG. 5 is a block configuration diagram of a battery diagnosis device according to an embodiment of the present disclosure; and FIGS. 6 and 7 are diagrams of a process of analyzing the behavior of a cell voltage change rate of battery cells in the battery diagnosis device according to an embodiment of the present disclosure.

Referring to FIG. 5, the battery diagnosis device of an embodiment may include a memory 100 and a processor 400, and each of the components 100 and 400 may constitute a battery pack along with battery cells (and a plurality of battery modules composed of a plurality of battery cells) which are abnormality diagnosis targets in the embodiment.

At least one command executed by the processor 400 to be described below may be stored in the memory 100. The memory 100 may be implemented as a volatile storage medium and/or a non-volatile storage medium, and may be implemented as, for example, a read only memory (ROM) and/or a random access memory (RAM).

Further, a plurality of types of threshold data required in a process in which a battery cell abnormality is diagnosed by the processor 400 may be stored in the memory 100, and the plurality of types of threshold data may include a reference state of charge (SOC), a reference voltage change rate, a reference open circuit voltage (OCV) change rate, and first to third counting values. As will be described below, the plurality of types of threshold data stored in the memory 100 may be utilized in a process of specifying abnormal cell candidates or finally classifying abnormal cells. The value of each type of threshold data may be predefined based on the specifications of a battery system and experimental results of the designer. The values may be discrete values or suitable ranges of values.

The processor 400 is an entity which diagnoses abnormality in battery cells, and may be implemented as a central processing unit (CPU) or a system on chip (SoC), control a plurality of hardware or software components connected to the processor 400 by driving an operating system or application, and may perform various types of data processing and calculations. The processor 400 may be configured to execute at least one command stored in the memory 100 and store the execution result data in the memory 100. In an embodiment, the processor 400 may be implemented as a battery management system (BMS) provided in the battery pack or a micro controller unit (MCU) in the BMS, and may be configured to detect a current, a voltage, an open circuit voltage (OCV), and a temperature of the battery cells, as is well known. A sensing function of the BMS may support sensing operations for parameters (the cell voltage and OCV) considered when a battery cell abnormality is diagnosed.

In an embodiment, the abnormality of the battery cell to be diagnosed may mean an internal short circuit in the cell due to lithium salt precipitation occurring on the negative electrode surface of the battery cell, for example. Two embodiments for a method of diagnosing this battery cell abnormality are presented below, and each embodiment will be distinguished and described.

### (1) First embodiment

The first embodiment focuses on a configuration which improves the reliability of battery cell abnormality diagnosis using a change in behavior (or a trend) of a cell voltage change rate of the battery cell as a basic analysis factor and a maximum value of the cell voltage change rate and a change rate of the open circuit voltage of the battery cell as additional analysis factors.

First, the processor 400 may determine whether the state of charge (SOC) of the battery cell has been formed (or established) as a reference SOC (e.g., a predefined reference SOC) in the memory 100. This embodiment is configured to diagnose a battery cell abnormality based on a change in behavior (or trend) of the cell voltage change rate which appears during self-discharging due to an internal short circuit of the battery cell, and a state in which the SOC of the battery cell has been formed (or established) as the reference SOC (e.g., a predefined reference SOC) is assumed as a preliminary state for self-discharge of the battery cell.

If the SOC of the battery cell has been formed (or established) below the reference SOC, the processor 400 may operate to form (or establish) the SOC of the battery cell as the reference SOC through a certain charging method (for example, a constant current-constant voltage (CC-CV) charging method). In other words, to form the SOC as the reference SOC, the battery cell may be charged until the reference SOC of the battery is reached. In this case, considering that there may be a fluctuation in the cell voltage of the battery cell for a certain period of time after the charging of the battery cell is completed, the processor 400 may be configured to wait for a reference time (e.g., a predefined reference time) for the cell voltage of the battery cell to stabilize and then start an abnormality diagnosis operation. A state in which the cell voltage is stabilized may be a state in which a cell voltage fluctuation range of the battery cell is within an allowable range (e.g., a predefined allowable range), and the above-mentioned reference time required to enter this cell voltage stabilization state may be selected as a specific value according to specifications of the battery system and may be predefined in the memory 100 (for example, more than 10 minutes, 1 hour, 2, hours, 3 hours, 4 hours, 5 hours, or a value of more than 5 hours).

When the SOC of the battery cell has been formed as (or established as, or brought to) the reference SOC and the cell voltage enters the stabilized state after a reference time has elapsed, a factor (or cause) which changes the cell voltage formed (or established) in the battery cell may be specified as an abnormality of the battery cell itself, such as an internal short circuit, and, accordingly, the processor 400 may start abnormality diagnosis operation of the battery cell. In this embodiment, the change in behavior (or trend) of the cell voltage change rate of the battery cell is adopted as a basic factor considered for diagnosing a battery cell abnormality.

The above-described cell voltage change rate is a change rate of the cell voltage of the battery cell with respect to time, that is, may correspond to a first derivative of the cell voltage of the battery cell with respect to time (herein, referred to as a first derivative). Further, the change in behavior (or trend) of the cell voltage change rate may correspond to a second derivative of the battery cell with respect to time. When the battery cell is normal, the cell voltage tends to decrease due to self-discharge, and, assuming the above-described stabilized state, a decrease rate of the cell voltage (that is, a cell voltage decrease rate with respect to time) gradually decreases (that is, the first derivative gradually decreases).

If a short circuit occurs in the normal battery cell as described above, a self-discharge amount due to the internal short circuit may sharply increase, and, accordingly, the cell voltage decrease rate increases (that is, the first derivative increases).

That is, in the case of an abnormal battery cell in which a short circuit has occurred, the first derivative changes from a decreasing trend to an increasing trend, and the processor 400 of the embodiment is configured to diagnose a battery cell abnormality based on a change in behavior (or trend) of the first derivative (that is, the change in behavior (or trend) of the cell voltage change rate).

The processor 400 may determine whether the sign of a slope of the cell voltage change rate with respect to time changes to specify abnormal cell candidates composed of one or more battery cells predicted to have an abnormality. That is, a change in the sign of the slope of the cell voltage change rate with respect to time means that the above-described first derivative changes from a decreasing trend (a negative sign) to an increasing trend (a positive sign), and since this means that there is a possibility that an internal short circuit has occurred in the battery cell, the processor 400 may classify the corresponding battery cell as an abnormal cell candidate if the sign of the slope of the cell voltage change rate with respect to time has changed. This has the same meaning as classifying the battery cell having an inflection point of the cell voltage with respect to time (that is, the second derivative has a value of 0) as an abnormal cell candidate. FIG. 6 illustrates experimental data of a cell voltage curve over time of a normal battery cell and a cell voltage curve over time of four abnormal battery cells.

When the abnormal cell candidates are specified, the processor 400 may discharge the battery cells classified as the abnormal cell candidates and then block subsequent charging of the discharged battery cells. Accordingly, the risks of thermal runaway and ignition due to continuous use of battery cells suspected to have an internal short circuit may be eliminated or reduced.

To more accurately diagnose the battery cell abnormality, the processor 400 may diagnose the battery cell abnormality by further considering the maximum value of the cell voltage change rate and the change rate of the open circuit voltage, along with whether the slope of the cell voltage change rate has changed.

The processor 400 may classify the battery cell as an abnormal cell candidate if the sign of the slope (that is, the second derivative) of the cell voltage change rate of the battery cell with respect to time has changed (that is, if an inflection point is formed) and if the maximum value of the cell voltage change rate of the battery cell with respect to time (that is, the first derivative) is greater than or equal to the reference voltage change rate in (e.g., predefined in) the memory 100.

That is, a case in which the maximum value of the first derivative is greater than or equal to the reference voltage change rate means that a self-discharge rate of the corresponding battery cell is high, and, since this phenomenon may be caused by an internal short circuit of the battery cell, the processor 400 may more precisely diagnose the battery cell abnormality by additionally considering the maximum value of the first derivative along with whether the sign of the second derivative has changed. FIG. 7 illustrates experimental data of the first derivative of a normal battery cell and first derivatives of four abnormal battery cells.

Further, the processor 400 may classify the battery cell as an abnormal cell candidate, if the sign of the slope of the cell voltage change rate with respect to time of the battery cell has changed and if the change rate of the open circuit voltage of the battery cell (a decrease rate of the open circuit voltage with respect to time) is greater than or equal to a reference OCV change rate (e.g., a predefined reference OCV change rate).

That is, since the case in which the decrease rate of the open circuit voltage of the battery cell is greater than or equal to the reference OCV change rate may be also seen as a state in which the self-discharge rate has increased due to the internal short circuit of the battery cell, the processor 400 may more precisely diagnose the battery cell abnormality by additionally considering the decrease rate of the open circuit voltage along with whether the sign of the second derivative has changed.

Further, an embodiment of classifying the battery cell as an abnormal cell candidate if the sign of the slope of the cell voltage change rate with respect to time of the battery cell changes, the maximum value of the cell voltage change rate with respect to time of the battery cell is greater than or equal to the reference voltage change rate, and the change rate of the open circuit voltage of the battery cell is greater than or equal to the reference OCV change rate may be provided.

To improve the accuracy of abnormal battery cell diagnosis, the processor 400 may determine whether a state in which an inflection point where the second derivative of the battery cell has a value of 0 is formed has occurred as many times as (or more often than) a first counting value defined in the memory 100, and/or may determine whether a state in which the maximum value of the first derivative is greater than or equal to the reference voltage change rate has occurred as many times as a second counting value defined in the memory 100, and/or may determine whether a state in which the change rate of the open circuit voltage is greater than or equal to the reference OCV change rate has occurred as many times as a third counting value defined in the memory 100. In an embodiment, the processor 400 may be configured to classify the corresponding battery cell as an abnormal cell candidate only if each of the above state has occurred as many times as the counting value.

Table 1 below shows experimental data comparing whether the inflection point is formed, the number of times the inflection point is formed, the maximum value of the first derivative, and the change rate of the open circuit voltage for four abnormal battery cells with those of a normal battery cell.

**Table 1**

| | Whether inflection point is formed | The number of times the inflection point is formed | Maximum value of the first derivative [mV/5hr] | Change rate of open circuit voltage (mV/hour) |
|---|---|---|---|---|
| Normal cell | X | 0 | 3 | 0.6 |
| Abnormal cell1 | O | 5 | 310 | 62 |
| Abnormal cell2 | O | 3 | 11 | 2.2 |
| Abnormal cell3 | O | 3 | 17 | 3.4 |
| Abnormal cell4 | O | 3 | 9 | 1.8 |

Based on the experimental data as shown in Table 1, the reference SOC, the reference voltage change rate, the reference OCV change rate, and the first to third counting values presented as threshold data in the embodiment may be selected as specific numerical values and predefined in the memory 100, and, for example, the reference SOC may be predefined as a value of 80[%], the reference voltage change rate may be predefined as a value of 4 [mV/5 hours], the reference OCV change rate may be predefined as a value of 0.7 [mV/hour], and the first to third counting values may be respectively predefined as values of 2, 3, and 2.

### (2) Second embodiment

The second embodiment focuses on a configuration which precisely diagnoses battery cell abnormalities within (or from) a range in which normal operation of the battery system is secured by performing a discharge operation and an additional charge blocking operation only for the battery cells finally classified as having an abnormality through a stepwise monitoring and classification operation of monitoring "the second derivative" and "the maximum value of the first derivative" of the above-described plurality of battery cells to primarily classify the abnormal cell candidates, and monitoring "the open circuit voltage" of the primarily classified abnormal cell candidates to finally classify the abnormal cells. The period in which the diagnosis is carried out can be more than one hour, or several hours.

Terms used in the second embodiment will be defined first. The first parameter indicated below may be defined as a behavior (or trend) of the cell voltage change rate which appears when the battery cell is discharged, and may include a change in behavior (or trend) of the cell voltage change rate (that is, the second derivative) and the maximum value of the cell voltage change rate (that is, the maximum value of the first derivative) described in the first embodiment. Further, the second parameter may be defined as the change rate of the open circuit voltage which appears when the battery cell is discharged.

The processor 400 may diagnose the battery cell abnormality in a stepwise manner through stepwise monitoring of the above-described first and second parameters. That is, the processor 400 may (e.g., in a first step) operate to specify abnormal cell candidates by monitoring the first parameter among the first and second parameters first and determining one or more battery cells predicted (suspected) to have an abnormality among the plurality of battery cells, and then to finally (e.g., in a second step) classify the battery cells in which the abnormality has occurred by subsequently monitoring the second parameter for the specified abnormal cell candidates. In this case, like the first embodiment, an operation of determining whether the SOC of the battery cell has been formed (or established) as the reference SOC and an operation of waiting for the reference time may also be equally applied to the second embodiment.

The operation of the processor 400 will be described in further detail.

First, the processor 400 may monitor the first parameter in a manner of determining whether the sign of the slope of the cell voltage change rate of the battery cell with respect to time changes, and whether the maximum value of the cell voltage change rate of the battery cell with respect to time is greater than or equal to the predefined reference voltage change rate. That is, the processor 400 may monitor the first parameter in a manner of determining whether the first derivative has changed from the decreasing trend (the negative sign) to the increasing trend (the positive sign) (whether the inflection point of the cell voltage with respect to time has been formed) and whether the maximum value of the first derivative is greater than or equal to the reference voltage change rate.

In the above process, if it is determined that the sign of the slope of the cell voltage change rate of the battery cell with respect to time changes and the maximum value of the cell voltage change rate of the battery cell with respect to time is greater than or equal to the predefined reference voltage change rate (that is, if it is determined that the inflection point of the cell voltage with respect to time is formed and the maximum value of the first derivative is greater than or equal to the reference voltage change rate), the processor 400 may primarily classify the battery cell as an abnormal cell candidate. Unlike the first embodiment, the discharge operation and the additional charge blocking operation for the battery cell classified as an abnormal cell candidate are excluded in the second embodiment.

If the abnormal cell candidates are primarily classified, the processor 400 may monitor the second parameter for the primarily classified abnormal cell candidates, and may finally classify the battery cells as abnormal cell candidates if the change rate of the open circuit voltage of the battery cell included in the abnormal cell candidates is greater than or equal to the predefined reference OCV change rate. Thereafter, the processor 400 may operate to discharge the battery cell corresponding to the finally classified abnormal cell and then block subsequent charging of the battery cell.

In the above second embodiment, the first parameter corresponding to the "behavior of the cell voltage change rate" is utilized as a parameter for detecting the sign of an abnormality such as an internal short circuit of the battery, and the second parameter corresponding to the "change rate of the open circuit voltage" is utilized as a parameter for detecting a result of the abnormality. If the sign of an abnormality in the battery cell is detected through monitoring of the first parameter, the battery cell is classified as an abnormal cell candidate and the normal operation of the battery cell is maintained, and if the result of the abnormality in the battery cell is detected through monitoring of the second parameter of the battery cell belonging to the abnormal cell candidates, the battery cell is finally classified as an abnormal battery cell and the discharge operation and the additional charge blocking operation for the corresponding battery cell are performed. Accordingly, even if the sign of the abnormality is detected, the normal operation of the battery system is maintained until the abnormal battery cell is finally confirmed, and, accordingly, an unnecessary discharge operation and additional charge blocking operation may be prevented from being performed on the battery cell.

### 3. Battery diagnosis method

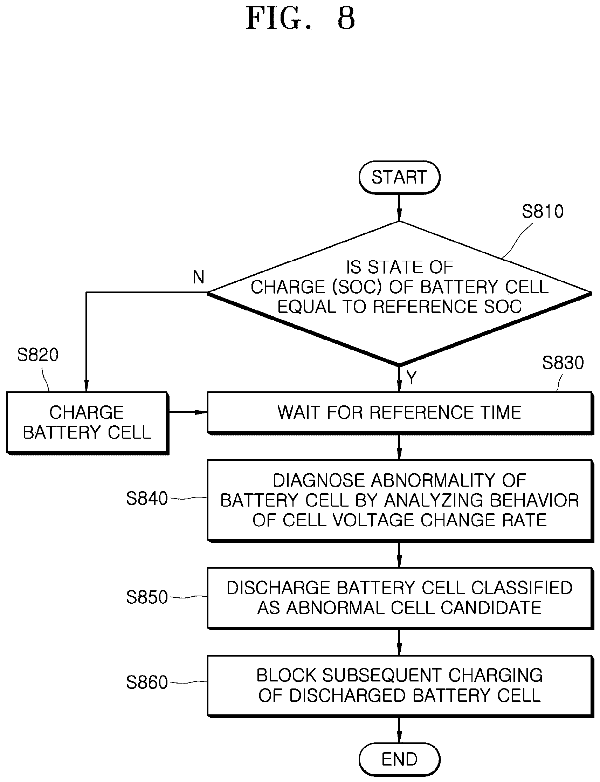

FIG. 8 is a flowchart of a battery diagnosis method according to the above-described first embodiment. Referring to FIG. 8, the battery diagnosis method according to the first embodiment will be described, specific description of configurations overlapping the above-described contents may be omitted, and description will be focused on a time-series configuration.

First, the processor 400 determines whether an SOC of the battery cell has been formed (or established) as a reference SOC (e.g., a predefined reference SOC) in the memory 100 (S810). If it is determined that the SOC of the battery cell has been formed (or established) below the reference SOC in operation S810, the processor 400 forms the SOC of the battery cell as the reference SOC through a certain charging method (for example, a constant current-constant voltage (CC-CV) charging method) (S820).

If it is determined that the SOC of the battery cell has been formed (or established) as the reference SOC in operation S810, or if the SOC of the battery cell has been formed (or established) as the reference SOC through operation S820, the processor 400 waits for a reference time to stabilize a cell voltage of the battery cell (S830).

At the time point when the reference time has elapsed, the processor 400 diagnoses a battery cell abnormality in a manner of analyzing a change in behavior (or trend) of a cell voltage change rate which appears when the battery cell is discharged (S840). In other words, the processor 400 may monitor a cell voltage change rate of the battery cell. The processor 400 may also monitor the temporal course of the voltage change rate of the battery cell.

In operation S840, the processor 400 may determine whether the sign of the slope of the cell voltage change rate with respect to time changes to specify abnormal cell candidates composed of one or more battery cells predicted to have an abnormality, and may classify the battery cell as an abnormal cell candidate if the sign of the slope of the cell voltage change rate of the battery cell with respect to time has changed.

In operation S840, the processor 400 may classify the corresponding battery cell as an abnormal cell candidate: i) if the sign of the slope of the cell voltage change rate of the battery cell with respect to time has changed and when a maximum value (or a maximum value of the magnitude) of the cell voltage change rate of the battery cell with respect to time is greater than or equal to a reference voltage change rate (e.g., a predefined reference voltage change rate); or ii) if the sign of the slope of the cell voltage change rate of the battery cell with respect to time has changed and if a change rate of an open circuit voltage of the battery cell is greater than or equal to a reference OCV change rate.

If the abnormal cell candidates are specified through operation S840, the processor 400 discharges the battery cells classified as the abnormal cell candidates (S850) and blocks subsequent charging of the discharged battery cells (S860).

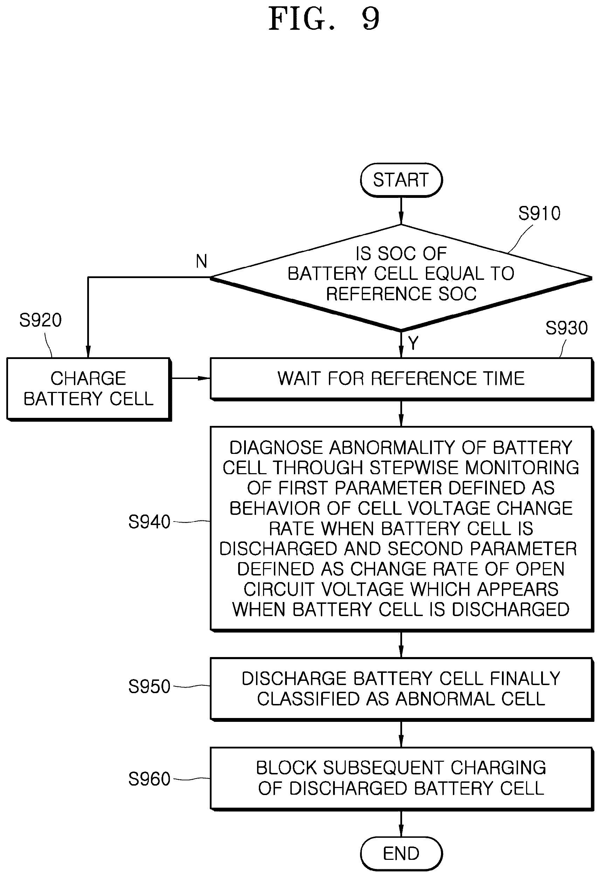

FIG. 9 is a flowchart of a battery diagnosis method according to the above-described second embodiment. Referring to FIG. 9, the battery diagnosis method according to the second embodiment will be described.

First, the processor 400 determines whether an SOC of the battery cell has been formed (or established) as a reference SOC (e.g., a predefined reference SOC) in the memory 100 (S910). If it is determined that the SOC of the battery cell has been formed (or established) below the reference SOC in operation S910, the processor 400 forms (or establishes) the SOC of the battery cell as the reference SOC through a certain charging method (for example, a constant current-constant voltage (CC-CV) charging method) (S920).

If it is determined that the SOC of the battery cell has been formed (or established) as the reference SOC in operation S910, or if the SOC of the battery cell has been formed (or established) as the reference SOC through operation S920, the processor 400 waits for a reference time to stabilize a cell voltage of the battery cell (S930).

At the time point when the reference time has elapsed, the processor 400 diagnoses a battery cell abnormality through stepwise monitoring of a first parameter defined as the behavior (or trend) of a cell voltage change rate when the battery cell is discharged and a second parameter defined as a change rate of an open circuit voltage which appears when the battery cell is discharged (S940).

In operation S940, the processor 400 may monitor the first parameter in a manner of determining whether a sign of a slope of the cell voltage change rate of the battery cell with respect to time changes, and whether a maximum value (or a maximum value of a magnitude) of the cell voltage change rate of the battery cell with respect to time is greater than or equal to a reference voltage change rate (e.g., a predefined reference voltage change rate). In this case, the processor 400 may primarily classify the battery cell as an abnormal cell candidate, if the sign of the slope of the cell voltage change rate of the battery cell with respect to time has changed and if the maximum value (or the maximum value of the magnitude) of the cell voltage change rate of the battery cell with respect to time is greater than or equal to the reference voltage change rate.

Thereafter, the processor 400 may monitor the second parameter for the primarily classified abnormal cell candidates, and may finally classify the battery cells as abnormal cells when the change rate of the open circuit voltage of the battery cells included in the abnormal cell candidates is greater than or equal to a reference OCV change rate.

When the abnormal cells are finally classified through operation S940, the processor 400 may discharge the battery cells corresponding to the finally classified abnormal cells (S950) and block subsequent charging of the battery cells (S960).

Thus, according to one or more embodiments of the present disclosure, as a battery cell abnormality is diagnosed in a manner of analyzing the behavior (or trend) of a cell voltage change rate (that is, an inflection point of a cell voltage with respect to time) which appears when a battery cell having a certain state of charge (SOC) is discharged, a battery cell abnormality such as an internal short circuit in the battery cell due to lithium salt precipitation can be diagnosed in advance, and the risks of thermal runaway and ignition of the battery cell can be effectively eliminated or reduced through a discharge operation and an additional charge blocking operation for the battery cell predicted to have an abnormality.

Further, according to one or more embodiments of the present disclosure, as the battery cell abnormality is diagnosed by comprehensively considering a maximum value (or a maximum value of a magnitude) of the cell voltage change rate with respect to time and an open circuit voltage along with the inflection point of the cell voltage with respect to time, the accuracy of abnormality diagnosis can be improved.

In addition, according to one or more embodiments of the present disclosure, as the battery cell abnormality is diagnosed in a stepwise manner through stepwise monitoring of a first parameter defined as the behavior (or trend) of the cell voltage change rate which appears when the battery cell is discharged and a second parameter defined as an open circuit voltage which appears when the battery cell is discharged, and a discharge operation and an additional charge blocking operation are performed for only the battery cell (or battery cells) classified as having an abnormality, the risks of thermal runaway and ignition can be eliminated or reduced by diagnosing the battery cell abnormality in advance within a range in which normal operation of a battery system is secured.

According to one or more embodiments of the present disclosure, as a battery cell abnormality is diagnosed in a manner of analyzing the behavior (or trend) of a cell voltage change rate (that is, an inflection point of a cell voltage with respect to time) which appears when a battery cell having a certain state of charge (SOC) is discharged, a battery cell abnormality, such as an internal short circuit in the cell due to metal dendrites or lithium salts growing as the charge/discharge cycle progresses, can be diagnosed in advance, and the risks of thermal runaway and ignition of the battery cell can be effectively eliminated or reduced through a discharge operation and an additional charge blocking operation for the battery cell predicted to have an abnormality.

Further, according to one or more embodiments of the present disclosure, as the battery cell abnormality is diagnosed by comprehensively considering a maximum value (or a maximum value of a magnitude) of the cell voltage change rate with respect to time and an open circuit voltage along with the inflection point of the cell voltage with respect to time, the accuracy of abnormality diagnosis can be improved.

In addition, according to one or more embodiments of the present disclosure, as the battery cell abnormality is diagnosed in a stepwise manner through stepwise monitoring of a first parameter defined as the behavior (or trend) of the cell voltage change rate which appears when the battery cell is discharged and a second parameter defined as an open circuit voltage which appears when the battery cell is discharged, and a discharge operation and an additional charge blocking operation are performed for only the battery cell classified as having an abnormality, the risks of thermal runaway and ignition can be eliminated by diagnosing the battery cell abnormality in advance within a range in which normal operation of a battery system is secured.

However, aspects and effects that can be achieved through the present invention are not limited to the above-described aspects and effects, and other aspects and effects that are not described may be clearly understood by those skilled in the art from the detailed descriptions.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to some embodiments and drawings illustrating aspects thereof, the present disclosure is not limited thereto. Various modifications and variations can be made by a person skilled in the art to which the present disclosure belongs within the scope of the present disclosure and the appended claims.

## Claims

1. A battery diagnosis device comprising:
a processor (400) configured to diagnose an abnormality of a battery cell (10a); and
a memory (100) to store one or more commands executed by the processor (400),
wherein the processor (400) is configured to diagnose the abnormality of the battery cell (10a) by analyzing a change in behavior of a cell voltage change rate that appears when the battery cell (10a) is discharged in a state in which a state of charge, SOC, of the battery cell (10a) has been formed as a reference SOC.

2. The battery diagnosis device as claimed in claim 1, wherein the processor (400) is configured to start an abnormality diagnosis operation of the battery cell (10a) at a time point when a reference time for stabilizing a cell voltage of the battery cell (10a) has elapsed after the SOC of the battery cell (10a) has been formed as the reference SOC.

3. The battery diagnosis device as claimed in claim 1 or 2, wherein the processor (400) is configured to determine whether a sign of a slope of the cell voltage change rate with respect to time changes to specify abnormal cell candidates composed of one or more battery cells (10a) predicted to have an abnormality when analyzing the change in behavior of the cell voltage change rate of the battery cell (10a).

4. The battery diagnosis device as claimed in claim 3, wherein the processor (400) is configured to classify the battery cell (10a) as an abnormal cell candidate if the sign of the slope of the cell voltage change rate of the battery cell (10a) with respect to time has changed.

5. The battery diagnosis device as claimed in claim 3, wherein the processor (400) is configured to classify the battery cell (10a) as an abnormal cell candidate if the sign of the slope of the cell voltage change rate of the battery cell (10a) with respect to time has changed and if a maximum value of the cell voltage change rate of the battery cell (10a) with respect to time is greater than or equal to a reference voltage change rate.

6. The battery diagnosis device as claimed in one of claims 3 to 5, wherein the processor (400) is configured to classify the battery cell (10a) as an abnormal cell candidate if the sign of the slope of the cell voltage change rate of the battery cell (10a) with respect to time has changed and if a change rate of an open circuit voltage, OCV, of the battery cell (10a) is greater than or equal to a reference OCV change rate.

7. The battery diagnosis device as claimed in one of claims 3 to 6, wherein the processor (400) is configured to discharge the battery cell (10a) classified as an abnormal cell candidate, and then block subsequent charging of the discharged battery cell (10a).

8. A battery diagnosis device comprising:
a processor (400) configured to diagnose an abnormality of a battery cell (10a); and
a memory (100) to store one or more commands executed by the processor (400),
wherein the processor is configured to diagnose the abnormality of the battery cell (10a) through stepwise monitoring of a first parameter defined as a behavior of a cell voltage change rate that appears when the battery cell (10a) is discharged, and a second parameter defined as a change rate of an open circuit voltage, OCV, that appears when the battery cell (10a) is discharged.

9. The battery diagnosis device as claimed in claim 8, wherein the processor (400) is configured to determine whether a sign of a slope of the cell voltage change rate of the battery cell (10a) with respect to time changes, and whether a maximum value of the cell voltage change rate of the battery cell (10a) with respect to time is greater than or equal to a reference voltage change rate when monitoring the first parameter.

10. The battery diagnosis device as claimed in claim 8 or claim 9, wherein the processor (400) is configured to monitor the first parameter among the first and second parameters first, and primarily classify the battery cell (10a) as an abnormal cell candidate if the sign of the slope of the cell voltage change rate of the battery cell (10a) with respect to time has changed and if the maximum value of the cell voltage change rate of the battery cell (10a) with respect to time is greater than or equal to the reference voltage change rate.

11. The battery diagnosis device as claimed in claim 10, wherein the processor (400) is configured to monitor the second parameter for the primarily classified abnormal cell candidate, and finally classify the battery cell (10a) as an abnormal cell when a change rate of an open circuit voltage of the battery cell (10a) included in the abnormal cell candidate is greater than or equal to a predefined reference OCV change rate.

12. The battery diagnosis device as claimed in claim 11, wherein the processor (400) is configured to discharge the battery cell (10a) corresponding to the finally classified abnormal cell, and then block subsequent charging of the battery cell (10a).

13. The battery diagnosis device as claimed in one of claims 8 to 12, wherein the processor (400) is configured to monitor the first and second parameters that appear in a discharge process of the battery cell (10a) after a state of charge, SOC, of the battery cell (10a) has been formed as a reference SOC.

14. A battery diagnosis method comprising:
determining, by a processor (400), whether a state of charge, SOC, of a battery cell (10a) has been formed as a reference SOC; and
diagnosing, by the processor (400), an abnormality of the battery cell (10a) by analyzing a change in behavior of a cell voltage change rate that appears if the battery cell (10a) is discharged when the SOC of the battery cell (10a) has been formed as the reference SOC.

15. The battery diagnosis method as claimed in claim 14, wherein, in the diagnosing, the processor (400) determines whether a sign of a slope of the cell voltage change rate with respect to time changes to specify abnormal cell candidates composed of one or more battery cells (10a) predicted to have an abnormality when analyzing the change in behavior of the cell voltage change rate of the battery cell (10a), and
wherein, in the diagnosing, the processor (400) classifies the battery cell (10a) as an abnormal cell candidate if the sign of the slope of the cell voltage change rate of the battery cell (10a) with respect to time has changed.
